# EUROPEAN PATENT APPLICATION

(11) **EP 4 350 770 A1**
(43) Date of publication of application: **10.04.2024**
(21) Application number: 22810859.3
(22) Date of filing: 14.02.2022
(51) Int. Cl.: H01L 27/146, H01L 21/3205, H01L 21/768, H01L 23/522, H04N 5/374

(54) **SOLID-STATE IMAGING ELEMENT, METHOD FOR PRODUCING SOLID-STATE IMAGING ELEMENT, AND ELECTRONIC DEVICE**

(30) Priority: 27.05.2021 JP 2021089185
(71) Applicant: Sony Semiconductor Solutions Corporation, Atsugi-shi, Kanagawa 243-0014 (JP)
(72) Inventor: OOKI, Susumu, Atsugi-shi, Kanagawa 243-0014 (JP); HIRAMATSU, Katsunori, Atsugi-shi, Kanagawa 243-0014 (JP)
(74) Representative: MFG Patentanwälte Meyer-Wildhagen Meggle-Freund Gerhard PartG mbB
(86) International application number: PCT/JP2022/005561
(87) International publication number: WO 2022/249575

(57) **Abstract**

A solid-state imaging element (1) according to the present disclosure includes a semiconductor layer (20) and a separation region (23). The semiconductor layer (20) includes a plurality of photoelectric conversion sections disposed in a matrix. The separation region (23) separates the photoelectric conversion sections adjacent to each other in the semiconductor layer (20). The separation region (23) includes a wall-like electrode (24) and a low absorption member (26). The wall-like electrode (24) is disposed in a wall shape, and a negative bias voltage is applied thereto. The low absorption member (26) is disposed further on the light incident side than the wall-like electrode (24) and has a light absorption rate smaller than that of the wall-like electrode (24).

## Description

### Field

The present disclosure relates to a solid-state imaging element, a method of manufacturing a solid-state imaging element, and electronic equipment.

### Background

A solid-state imaging element includes, for example, a plurality of photoelectric conversion sections arrayed along a light incident side surface of a semiconductor layer. In such a solid-state imaging element, a technology for forming a conductive light blocking wall in a separation region located between adjacent photoelectric conversion sections has been known (see, for example, Patent Literature 1.).

### Citation List

### Patent Literature

Patent Literature 1: JP 2009-88030 A

### Summary

### Technical Problem

The present disclosure proposes a solid-state imaging element, a method of manufacturing a solid-state imaging element, and electronic equipment capable of suppressing deterioration in a condensing characteristic for a photoelectric conversion section. Solution to Problem

According to the present disclosure, there is provided a solid-state imaging element. The solid-state imaging element includes a semiconductor layer and a separation region. The semiconductor layer includes a plurality of photoelectric conversion sections disposed in a matrix. The separation region separates the photoelectric conversion sections adjacent to each other in the semiconductor layer. The separation region includes a wall-like electrode and a low absorption member. The wall-like electrode is disposed in a wall shape, and a negative bias voltage is applied thereto. The low absorption member is disposed further on the light incident side than the wall-like electrode and has a light absorption rate smaller than that of the wall-like electrode.

### Brief Description of Drawings

FIG. 1 is a system configuration diagram illustrating a schematic configuration example of a solid-state imaging element according to an embodiment of the present disclosure.
FIG. 2 is a sectional view schematically illustrating structure of a pixel array section according to the embodiment of the present disclosure.
FIG. 3 is a diagram for explaining a manufacturing step for the pixel array section according to the embodiment of the present disclosure.
FIG. 4 is a diagram for explaining the manufacturing step for the pixel array section according to the embodiment of the present disclosure.
FIG. 5 is a diagram for explaining the manufacturing step for the pixel array section according to the embodiment of the present disclosure.
FIG. 6 is a diagram for explaining the manufacturing step for the pixel array section according to the embodiment of the present disclosure.
FIG. 7 is a diagram for explaining the manufacturing step for the pixel array section according to the embodiment of the present disclosure.
FIG. 8 is a diagram for explaining the manufacturing step for the pixel array section according to the embodiment of the present disclosure.
FIG. 9 is a sectional view schematically illustrating structure of a pixel array section according to a modification 1 of the embodiment of the present disclosure.
FIG. 10 is a diagram illustrating a relation between depth at which a low absorption member is disposed and a saturation charge amount of a light receiving pixel in the modification 1 of the embodiment of the present disclosure.
FIG. 11 is a diagram for explaining a manufacturing step for the pixel array section according to the modification 1 of the embodiment of the present disclosure.
FIG. 12 is a diagram for explaining the manufacturing step for the pixel array section according to the modification 1 of the embodiment of the present disclosure.
FIG. 13 is a diagram for explaining the manufacturing step for the pixel array section according to the modification 1 of the embodiment of the present disclosure.
FIG. 14 is a diagram for explaining the manufacturing step for the pixel array section according to the modification 1 of the embodiment of the present disclosure.
FIG. 15 is a diagram for explaining the manufacturing step for the pixel array section according to the modification 1 of the embodiment of the present disclosure.
FIG. 16 is a diagram for explaining the manufacturing step for the pixel array section according to the modification 1 of the embodiment of the present disclosure.
FIG. 17 is a diagram for explaining the manufacturing step for the pixel array section according to the modification 1 of the embodiment of the present disclosure.
FIG. 18 is a sectional view schematically illustrating structure of a pixel array section according to a modification 2 of the embodiment of the present disclosure.
FIG. 19 is a sectional view schematically illustrating structure of a pixel array section according to a modification 3 of the embodiment of the present disclosure.
FIG. 20 is a sectional view schematically illustrating structure of a pixel array section according to a modification 4 of the embodiment of the present disclosure.
FIG. 21 is a diagram illustrating a planar configuration of a pixel array section according to a modification 5 of the embodiment of the present disclosure.
FIG. 22 is a diagram illustrating a planar configuration of a pixel array section according to a modification 6 of the embodiment of the present disclosure.
FIG. 23 is an arrow sectional view taken along line A-A illustrated in FIG. 22.
FIG. 24 is an arrow sectional view taken along line B-B illustrated in FIG. 22.
FIG. 25 is a block diagram illustrating a configuration example of an imaging device functioning as electronic equipment to which the technology according to the present disclosure is applied.
FIG. 26 is a block diagram depicting an example of schematic configuration of a vehicle control system.
FIG. 27 is a diagram of assistance in explaining an example of installation positions of an outside-vehicle information detecting section and an imaging section.

### Description of Embodiments

Embodiments of the present disclosure are explained in detail below with reference to the drawings. Note that, in the embodiments explained below, redundant explanation is omitted by denoting the same parts with the same reference numerals and signs.

A solid-state imaging element includes, for example, a plurality of photoelectric conversion sections arrayed along a light incident side surface of a semiconductor layer. In such a solid-state imaging element, there has been known a technology for forming a conductive light blocking wall in a separation region located between adjacent photoelectric conversion sections.

Further, by applying a negative bias voltage to the light blocking wall, holes can be collected in the vicinity of an interface between the photoelectric conversion section and the separation region. Therefore, occurrence of a dark current and white spots in the photoelectric conversion section can be suppressed.

On the other hand, in the related art explained above, since light absorption occurs in a light incident side part of the light blocking wall more or less, it is likely that an amount of light made incident on the photoelectric conversion section decreases.

Therefore, it is expected to realize a technology that can overcome the problems described above and suppress deterioration in a condensing characteristic for the photoelectric conversion section.

### [Configuration of a solid-state imaging element]

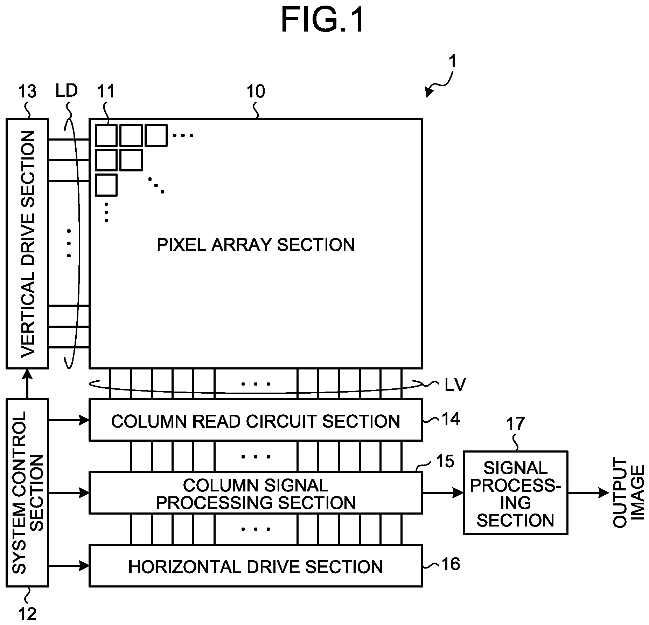

FIG. 1 is a system configuration diagram illustrating a schematic configuration example of a solid-state imaging element 1 according to an embodiment of the present disclosure. As illustrated in FIG. 1, a solid-state imaging element 1, which is a CMOS image sensor, includes a pixel array section 10, a system control section 12, a vertical drive section 13, a column read circuit section 14, a column signal processing section 15, a horizontal drive section 16, and a signal processing section 17.

The pixel array section 10, the system control section 12, the vertical drive section 13, the column read circuit section 14, the column signal processing section 15, the horizontal drive section 16, and the signal processing section 17 are provided on the same semiconductor substrate or on a plurality of electrically connected laminated semiconductor substrates.

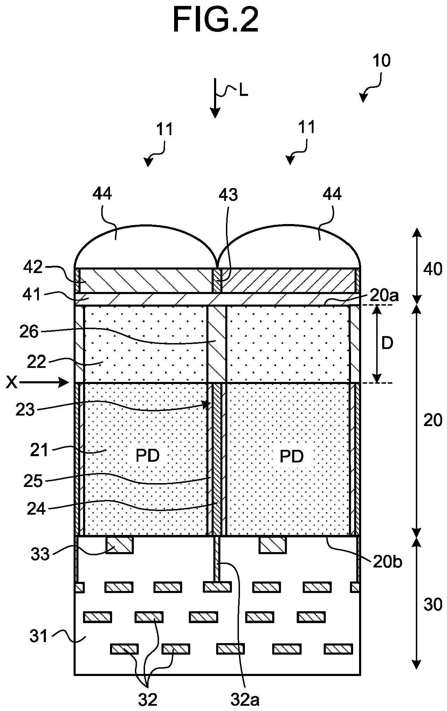

In the pixel array section 10, light receiving pixels 11 including photoelectric conversion elements (photodiodes PD (see FIG. 2)) capable of photoelectrically converting a charge amount corresponding to an incident light amount, accumulating the charge amount on the inside, and outputting the charge amount as a signal are two-dimensionally arranged in a matrix.

Besides the light receiving pixels 11, the pixel array section 10 sometimes includes a region where dummy pixels having a structure not including the photodiodes PD, light blocking pixels in which light incidence from the outside is blocked by shielding light receiving surfaces from light, and the like are arranged in rows and/or columns.

Note that the light blocking pixels may have the same configuration as the configuration of the light receiving pixels 11 except that the light-receiving surfaces are shielded from light. In the following explanation, a photoelectric charge of a charge amount corresponding to an amount of incident light is sometimes simply referred to as "charge" as well and the light receiving pixel 11 is sometimes simply referred to as "pixel" as well.

In the pixel array section 10, pixel drive lines LD are formed for each of the rows in the left-right direction in the drawing (an array direction of pixels in pixel rows) with respect to the pixel array in a matrix and vertical pixel wires LV are formed for each of the columns in the up-down direction in the drawing (an array direction of pixels in pixel columns). One ends of the pixel drive lines LD are connected to output ends corresponding to the rows of the vertical drive section 13.

The column read circuit section 14 includes at least a circuit that supplies, for each of the columns, a constant current to the light receiving pixels 11 in a selected row in the pixel array section 10, a current mirror circuit, and a changeover switch for the light receiving pixels 11 to be read.

The column read circuit section 14 configures an amplifier in conjunction with a transistor in the selected pixel in the pixel array section 10, converts a photoelectric charge signal into a voltage signal, and outputs the voltage signal to the vertical pixel wires LV.

The vertical drive section 13 includes a shift register and an address decoder and drives the light receiving pixels 11 of the pixel array section 10 at the same time for all pixels or in sections of rows. Although a specific configuration of the vertical drive section 13 is not illustrated, the vertical drive section 13 has a configuration including a read scanning system and a sweep scanning system or a batch sweeping and batch transfer system.

The read scanning system sequentially selects and scans the light receiving pixels 11 of the pixel array section 10 in sections of rows in order to read the pixel signal from the light receiving pixels 11. In the case of row driving (a rolling shutter operation), about sweeping, sweep scanning is performed on a read row on which read scanning is performed by the read scanning system prior to the read scanning by a time of a shutter speed.

In the case of global exposure (a global shutter operation), batch sweeping is performed prior to batch transfer by the time of the shutter speed. By such sweeping, unnecessary charges are swept (reset) from the photodiodes PD of the light receiving pixels 11 in the read row. Then, a so-called electronic shutter operation is performed by sweeping (resetting) the unnecessary charges.

Here, the electronic shutter operation means an operation for discarding unnecessary photoelectric charges accumulated in the photodiode PD until immediately before the electronic shutter operation and starting exposure anew (starting accumulation of photoelectric charges).

A signal read by the read operation by the read scanning system corresponds to an amount of light made incident after the immediately preceding read operation or electronic shutter operation. In the case of the row driving, a period from read timing by the immediately preceding read operation or sweep timing by the electronic shutter operation to read timing by the current read operation is a photoelectric charge accumulation time (an exposure time) in the light receiving pixels 11. In the case of the global exposure, a time from the batch sweeping to the batch transfer is an accumulation time (an exposure time).

Pixel signals output from the light receiving pixels 11 of a pixel row selectively scanned by the vertical drive section 13 are supplied to the column signal processing section 15 through each of the vertical pixel wires LV. The column signal processing section 15 performs, for each of the pixel columns of the pixel array section 10, predetermined signal processing on the pixel signals output from the light receiving pixels 11 of the selected row through the vertical pixel wire LV and temporarily holds the pixel signals after the signal processing.

Specifically, the column signal processing section 15 performs at least noise removal processing, for example, correlated double sampling (CDS) processing as the signal processing. By the CDS processing by the column signal processing section 15, fixed pattern noise specific to pixels such as reset noise and threshold variation of an amplification transistor AMP is removed.

Note that the column signal processing section 15 can be imparted with, for example, an AD conversion function besides the noise removal processing and configured to output a pixel signal as a digital signal.

The horizontal drive section 16 includes a shift register and an address decoder and sequentially selects section circuits corresponding to the pixel columns of the column signal processing section 15. By the selective scanning by the horizontal drive section 16, the pixel signals subjected to the signal processing by the column signal processing section 15 are sequentially output to the signal processing section 17.

The system control section 12 includes a timing generator that generates various timing signal and performs drive control for the vertical drive section 13, the column signal processing section 15, the horizontal drive section 16, and the like based on various timing signals generated by the timing generator.

The solid-state imaging element 1 further includes a signal processing section 17 and a not-illustrated data storage section. The signal processing section 17 has at least an addition processing function and performs various kinds of signal processing such as addition processing on the pixel signal output from the column signal processing section 15.

In signal processing in the signal processing section 17, the data storage section temporarily stores data necessary for the processing. The signal processing section 17 and the data storage section may be an external signal processing section provided on a substrate different from a substrate on which the solid-state imaging element 1 is provided, may perform, for example, processing by a digital signal processor (DSP) or software, or may be mounted on the same substrate as the substrate on which the solid-state imaging element 1 is mounted.

### [Embodiment]

Subsequently, a detailed configuration of the pixel array section 10 according to the embodiment is explained with reference to FIG. 2. FIG. 2 is a sectional view schematically illustrating structure of the pixel array section 10 according to the embodiment of the present disclosure.

As illustrated in FIG. 2, the pixel array section 10 according to the embodiment includes a semiconductor layer 20, a wiring layer 30, and an optical layer 40. In the pixel array section 10, an optical layer 40, a semiconductor layer 20, and a wiring layer 30 are laminated in order from a side on which light L from the outside is made incident (hereinafter also referred to as light incident side).

In the semiconductor layer 20, a photodiode PD is formed by a first region 21, which is a semiconductor region of a first conductivity type (for example, N-type), and a semiconductor region of a not-illustrated second conductivity type (for example, P-type) adjacent to the first region 21. The photodiode PD is an example of a photoelectric conversion section.

A second region 22, which is a semiconductor region of the second conductivity type, is provided in a part further on the light incident side than the first region 21 in the semiconductor layer 20. That is, the second region 22 having impurity concentration lower than that of such a first region 21 is provided in a part further on the light incident side than the first region 21 in the semiconductor layer 20.

In the semiconductor layer 20, separation regions 23 are provided among the photodiodes PD adjacent to one another. Such separation regions 23 electrically and optically separate the adjacent photodiodes PD from one another. For example, the separation regions 23 are arranged in a lattice shape in plan view in the pixel array section 10.

The separation region 23 according to the embodiment includes a wall-like electrode 24, an insulating film 25, and a low absorption member 26. The wall-like electrode 24 is a wall-like electrode made of a conductive material and provided along the separation region 23 in plan view. The wall-like electrode 24 is configured using one selected out of, for example, polysilicon, tungsten, and aluminum as a main component.

The wall-like electrode 24 is disposed, in the semiconductor layer 20, up to given depth X from a surface 20b on the opposite side of the light incident side (hereinafter also referred to as opposite surface 20b). The wall-like electrode 24 is disposed adjacent to the first region 21. That is, the first region 21 is disposed up to the given depth X from the opposite surface 20b in the semiconductor layer 20.

The insulating film 25 is disposed between the wall-like electrode 24 and the first region 21. The insulating film 25 is made of an insulative material (for example, silicon oxide (SiO₂)).

A wire 32a located in the wiring layer 30 is connected to the wall-like electrode 24 and a negative bias voltage is applied to the wall-like electrode 24 via the wire 32a and the like. The negative bias voltage is applied to the wall-like electrode 24, whereby holes can be collected in the vicinity of the interface between the photodiode PD and the separation region 23. Consequently, in the embodiment, occurrence of a dark current and white spots can be suppressed in the photodiode PD.

On the other hand, since the wall-like electrode 24 has a relatively large absorption rate for the light L, when the wall-like electrode 24 is disposed up to the vicinity of the surface 20a on the light incident side of the semiconductor layer 20 (hereinafter also referred to as light incident surface 20a), the wall-like electrode 24 is likely to absorb the light L in the vicinity of the light incident surface 20a.

Therefore, in the embodiment, as illustrated in FIG. 2, the low absorption member 26 is disposed in a part further on the light incident side than the wall-like electrode 24 in the separation region 23. For example, the low absorption member 26 has thickness substantially equal to that of a wall-like part configured by the wall-like electrode 24 and the insulating film 25.

The low absorption member 26 is made of a material having a lower absorption rate for the light L than that of the wall-like electrode 24 (for example, silicon oxide, hafnium oxide (HfO₂), aluminum oxide (Al₂O₃), or titanium oxide (TiO₂)).

Consequently, it is possible to prevent the light L from being absorbed in a part on the light incident side in the separation region 23. Therefore, according to the embodiment, it is possible to suppress deterioration in a condensing characteristic for the photodiode PD.

In the embodiment, the second region 22 having impurity concentration lower than that of the first region 21 is preferably disposed adjacent to the low absorption member 26. Consequently, even in the vicinity of the interface between the low absorption member 26 to which a negative bias voltage is not applied and the second region 22, occurrence of abnormal charges due to a defect or the like of the semiconductor layer 20 can be suppressed.

Therefore, according to the embodiment, occurrence of white spots in the photodiode PD can be suppressed.

In the example illustrated in FIG. 2, an example in which the second region 22 is the semiconductor region of the second conductivity type is illustrated. However, the second region 22 is not limited to the semiconductor region of the second conductivity type and may be configured by, for example, an impurity region of the first conductivity type having impurity concentration lower than that of the first region 21.

In the embodiment, the wall-like electrode 24 is preferably configured using one selected out of polysilicon, tungsten, and aluminum as a main component. Consequently, holes can be stably collected in the vicinity of the interface between the photodiode PD and the separation region 23.

Therefore, according to the embodiment, occurrence of a dark current and white spots in the photodiode PD can be further suppressed.

In the embodiment, the wall-like electrode 24 is preferably made of polysilicon. Consequently, it is possible to prevent the wall-like electrode 24 from being deteriorated even when the wall-like electrode 24 is exposed to a high-temperature environment in a manufacturing step for the pixel array section 10 explained below.

In the embodiment, the low absorption member 26 is preferably configured using one selected out of silicon oxide, hafnium oxide, aluminum oxide, and titanium oxide as a main component. For example, when the low absorption member 26 is made of silicon oxide, the low absorption member 26 can be easily formed.

When the low absorption member 26 is made of hafnium oxide, aluminum oxide, or titanium oxide, a refractive index difference between the low absorption member 26 and the second region 22 made of silicon can be reduced.

Therefore, according to the embodiment, since scattering of the light L can be suppressed at the end portion on the light incident side in the low absorption member 26, it is possible to further suppress deterioration of the condensing characteristic for the photodiode PD.

Explanation of other parts in the pixel array section 10 is continued. The wiring layer 30 is disposed on the opposite surface 20b of the semiconductor layer 20. Such a wiring layer 30 is configured by forming a plurality of layers of wires 32 and a plurality of pixel transistors 33 in an interlayer insulating film 31.

The wires 32 include a wire 32a electrically connected to the wall-like electrode 24. The plurality of pixel transistors 33 perform, for example, reading of charges accumulated in the photodiode PD.

The optical layer 40 is disposed on the light incident surface 20a of the semiconductor layer 20. The optical layer 40 includes a planarization film 41, a color filter 42, a light blocking wall 43, and an OCL (On-Chip Lens) 44.

The planarization film 41 is provided in order to planarize the surface on which the color filter 42 and the OCL 44 are formed and avoid unevenness caused in a rotational coating step at the time when the color filter 42 and the OCL 44 are formed.

The planarization film 41 is formed of, for example, an organic material (for example, acrylic resin). Note that the planarization film 41 is not limited to be formed of the organic material and may be formed of silicon oxide, silicon nitride (SiN), or the like.

The color filter 42 is an optical filter that transmits light having a predetermined wavelength in the light L condensed by the OCL 44. The color filter 42 is disposed on the surface on the light incident side of the planarization film 41.

The color filter 42 includes, for example, a color filter that transmits red light, a color filter that transmits green light, and a color filter that transmits blue light.

The light blocking wall 43 is disposed, for example, between adjacent color filters 42. The light blocking wall 43 is a wall-like film that blocks light obliquely made incident from the adjacent color filters 42. The light blocking wall 43 is made of, for example, aluminum, tungsten, or the like.

The OCL 44 is a lens that is provided for each light receiving pixel 11 and condenses the light L on the photodiode PD of each of the light receiving pixels 11. The OCL 44 is made of, for example, resin such as an acrylic resin.

### [Manufacturing step for the pixel array section]

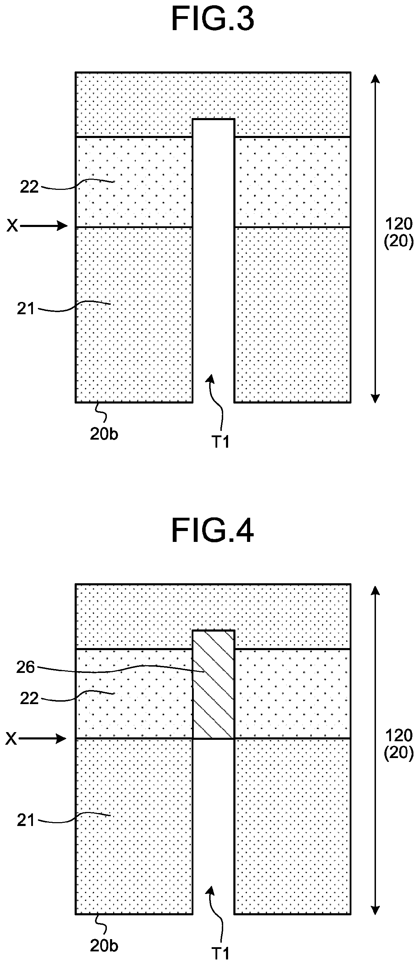

Subsequently, a manufacturing step for the pixel array section 10 according to the embodiment is explained with reference to FIG. 3 to FIG. 8. FIG. 3 to FIG. 8 are diagrams for explaining the manufacturing step for the pixel array section 10 according to the embodiment of the present disclosure.

In the manufacturing step for the pixel array section 10, as illustrated in FIG. 3, first, impurities of the second conductivity type are ion-implanted with high energy from the opposite surface 20b side of the semiconductor substrate 120 that includes impurities of the first conductivity type and finally becomes the semiconductor layer 20. Consequently, the second region 22 is formed in a region deeper than the given depth X based on the opposite surface 20b.

At this time, a region closer to the opposite surface 20b than the second region 22 in the semiconductor substrate 120 (the semiconductor layer 20) becomes the first region 21 of the first conductivity type.

Further, a trench T1 is formed on the opposite surface 20b side of the semiconductor substrate 120 (the semiconductor layer 20) by a method publicly known in the past. Note that the trench T1 is formed to pierce through the first region 21 and reach halfway in the second region 22 and is formed in a part where the separation region 23 is provided in plan view.

Subsequently, as illustrated in FIG. 4, the trench T1 is filled with the low absorption member 26 up to the given depth X from the bottom thereof by a method publicly known in the past.

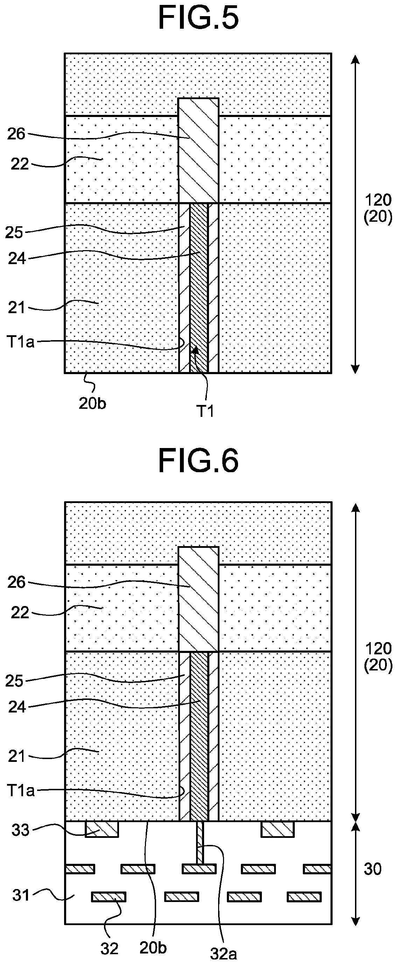

Subsequently, as illustrated in FIG. 5, the insulating film 25 is formed on a side surface T1a from the given depth X to an opening of the trench T1 by a method publicly known in the past and the wall-like electrode 24 is further formed by a method publicly known in the past fill the remaining space of the trench T1.

Subsequently, as illustrated in FIG. 6, the wiring layer 30 is formed on the surface of the opposite surface 20b of the semiconductor substrate 120 (the semiconductor layer 20). Such a wiring layer 30 is configured by providing the plurality of layers of wires 32 and the plurality of pixel transistors 33 in the interlayer insulating film 31 and is formed by a method publicly known in the past.

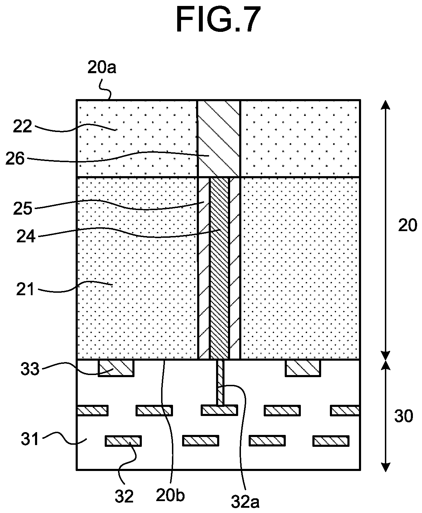

Subsequently, as illustrated in FIG. 7, the surface on the opposite side of the opposite surface 20b in the semiconductor substrate 120 is ground and is thinned such that the second region 22 and the low absorption member 26 are exposed. Consequently, the semiconductor layer 20 and the light incident surface 20a are formed.

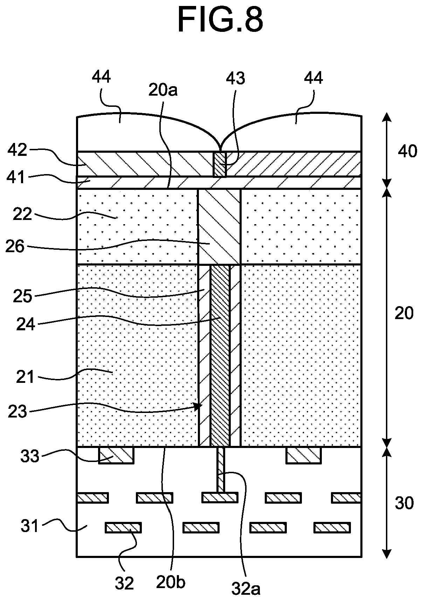

Subsequently, as illustrated in FIG. 8, the planarization film 41, a plurality of color filters 42, a plurality of light blocking walls 43, and a plurality of OCLs 44 are formed in order on the surface of the light incident surface 20a of the semiconductor layer 20.

As explained above, in the manufacturing step for the pixel array section 10 according to the embodiment, the separation region 23 is formed by filling the trench T1 formed from the opposite surface 20b of the semiconductor layer 20 with the low absorption member 26, the insulating film 25, and the wall-like electrode 24.

Consequently, it is possible to form the low absorption member 26, the insulating film 25, and the wall-like electrode 24 in a simple step and it is possible to prevent positional deviation between the low absorption member 26 and the wall-like electrode 24.

### [Various modifications]

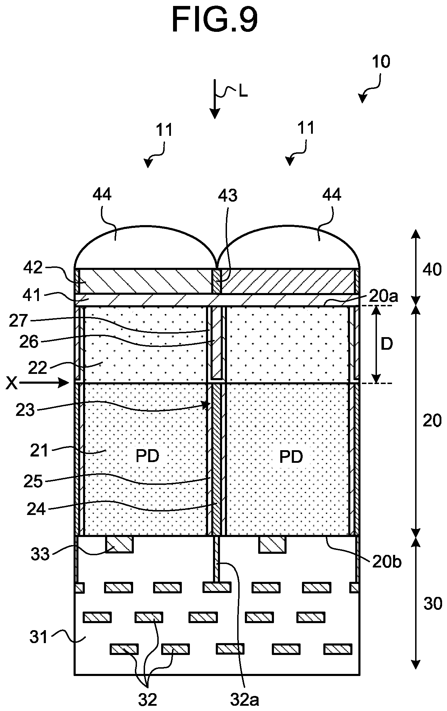

Subsequently, various modifications of the embodiment are explained with reference to FIG. 9 to FIG. 24.

### <Modification 1>

FIG. 9 is a sectional view schematically illustrating structure of the pixel array section 10 according to a modification 1 of the embodiment of the present disclosure. In the modification 1, a configuration of the low absorption member 26 and the periphery thereof is different from that in the embodiment explained above.

Specifically, as illustrated in FIG. 9, in the modification 1, a fixed charge film 27 is disposed between the low absorption member 26 and the second region 22 and the wall-like electrode 24. Such a fixed charge film 27 has a function of fixing charges (here, holes) to an interface between the separation region 23 and the second region 22.

As the material of the fixed charge film 27, it is preferable to use a high dielectric material having a lot of fixed charges. The fixed charge film 27 is made of, for example, hafnium oxide, aluminum oxide, tantalum oxide, zirconium oxide (ZrO₂), titanium oxide, magnesium oxide (MgOz), lanthanum oxide (La₂O₃), or the like.

The fixed charge film 27 may be made of praseodymium oxide (Pr₂O₃), cerium oxide (CeO₂), neodymium oxide (Nd₂O₃), promethium oxide (Pm₂O₃), samarium oxide (Sm₂O₃), europium oxide (Eu₂O₃), or the like.

The fixed charge film 27 may be made of gadolinium oxide (Gd₂O₃), terbium oxide (Tb₂O₃), dysprosium oxide (Dy₂O₃), holmium oxide (Ho₂O₃), erbium oxide (Er₂O₃), thulium oxide (Tm₂O₃), or the like.

The fixed charge film 27 may be made of ytterbium oxide (Yb₂O₃), lutetium oxide (Lu₂O₃), yttrium oxide (Y₂O₃), aluminum nitride (AlN), hafnium oxynitride (HfON), an aluminum oxynitride film (AlON), or the like.

By disposing such a fixed charge film 27, in the modification 1, it is possible to further suppress occurrence of abnormal charges due to a defect or the like of the semiconductor layer 20 in the vicinity of the interface between the low absorption member 26 to which a negative bias voltage is not applied and the second region 22.

Therefore, according to the modification 1, occurrence of white spots in the photodiode PD can be further suppressed.

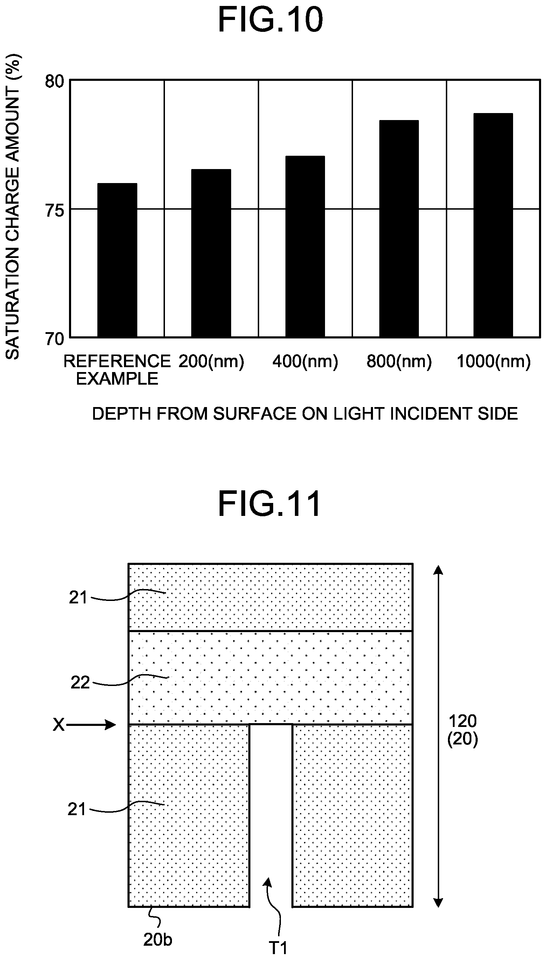

FIG. 10 is a diagram illustrating a relation between depth D at which the low absorption member 26 is disposed and a saturation charge amount of the light receiving pixel 11 in the modification 1 of the embodiment of the present disclosure.

Note that results illustrated in FIG. 10 are data obtained from simulation and are data in the case in which the fixed charge film 27 is configured by a multilayer film of aluminum oxide and tantalum oxide and the low absorption member 26 is configured by silicon oxide. A reference example illustrated in FIG. 10 is data in the case in which the low absorption member 26 and the fixed charge film 27 are not disposed and the wall-like electrode 24 pierces through the entire separation region 23.

As illustrated in FIG. 10, in the modification 1, it is more preferable that the low absorption member 26 is disposed up to the depth D of 800 (nm) or more from the light incident surface 20a of the semiconductor layer 20. Consequently, the saturation charge amount can be greatly increased as compared with the reference example. That is, in the modification 1, by disposing the low absorption member 26 up to the depth D of 800 (nm) or more, the condensing characteristic can be further improved.

Note that the data illustrated in FIG. 10 is a result of simulating the configuration of the modification 1. However, a result of simulating the configuration of the embodiment explained above is the same as the result illustrated in FIG. 10. That is, in the embodiment as well, the condensing characteristic can be further improved by disposing the low absorption member 26 up to the depth D of 800 (nm) or more.

### <Manufacturing step in the modification 1>

Subsequently, a manufacturing step for the pixel array section 10 according to the modification 1 is explained with reference to FIG. 11 to FIG. 17. FIG. 11 to FIG. 17 are diagrams for explaining a manufacturing step for the pixel array section 10 according to the modification 1 of the embodiment of the present disclosure.

In the manufacturing step in the modification 1, as illustrated in FIG. 11, first, impurities of the second conductivity type are ion-implanted with high energy from the opposite surface 20b side of the semiconductor substrate 120 that includes impurities of the first conductivity type and finally becomes the semiconductor layer 20. Consequently, the second region 22 is formed in a region deeper than the given depth X based on the opposite surface 20b.

At this time, a region closer to the opposite surface 20b than the second region 22 in the semiconductor substrate 120 (the semiconductor layer 20) becomes the first region 21 of the first conductivity type.

Further, a trench T1 is formed on the opposite surface 20b side of the semiconductor substrate 120 (the semiconductor layer 20) by a method publicly known in the past. Note that the trench T1 is formed to pierce through the first region 21 and is formed in a part where the separation region 23 is provided in plan view.

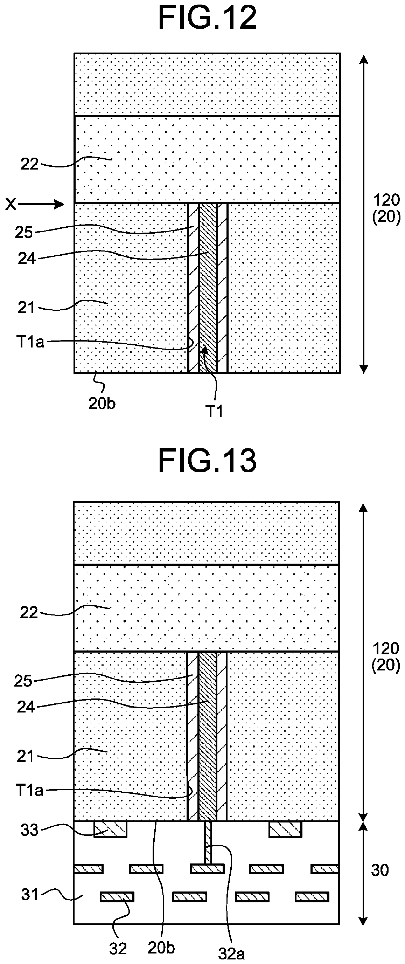

Subsequently, as illustrated in FIG. 12, the insulating film 25 is formed on the side surface T1a from the bottom to the opening of the trench T1 by a method publicly known in the past and the wall-like electrode 24 is further formed by a method publicly known in the past to fill the remaining space of the trench T1.

Subsequently, as illustrated in FIG. 13, a wiring layer 30 is formed on the surface of the opposite surface 20b of the semiconductor substrate 120 (the semiconductor layer 20). Such a wiring layer 30 is configured by providing the plurality of layers of wires 32 and the plurality of pixel transistors 33 in the interlayer insulating film 31 and is formed by a method publicly known in the past.

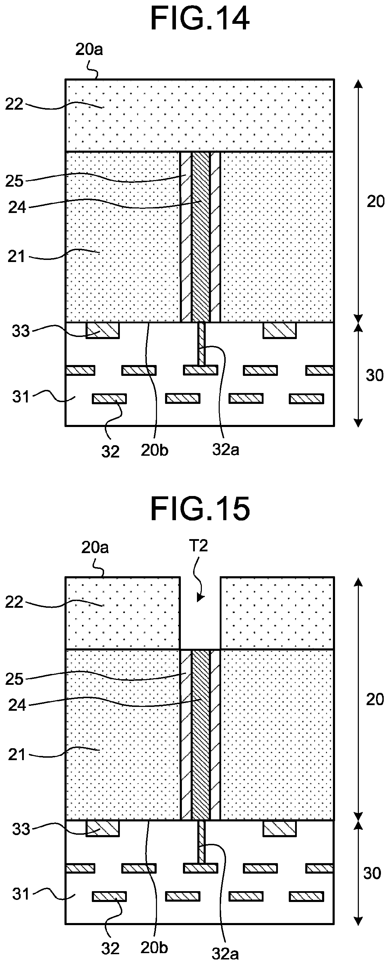

Subsequently, as illustrated in FIG. 14, the surface on the opposite side the opposite surface 20b in the semiconductor substrate 120 is ground and is thinned such that the second region 22 is exposed. Consequently, the semiconductor layer 20 and the light incident surface 20a are formed.

Subsequently, as illustrated in FIG. 15, a trench T2 is formed on the light incident surface 20a side of the semiconductor layer 20 by a method publicly known in the past. Note that the trench T2 is formed to pierce through the second region 22 and is formed in a part where the separation region 23 is provided in plan view. That is, the trench T2 is formed to expose the wall-like electrode 24 and the insulating film 25 at the bottom.

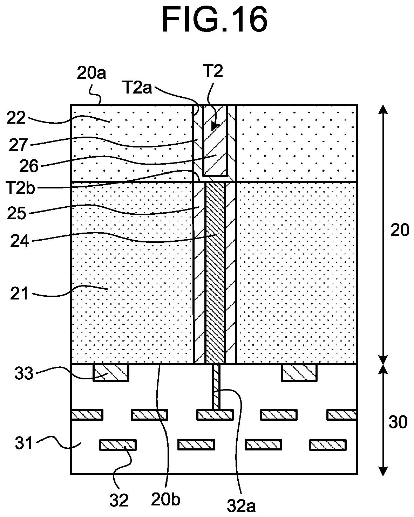

Subsequently, as illustrated in FIG. 16, the fixed charge film 27 is formed on a side surface T2a and a bottom surface T2b of the trench T2 by a method publicly known in the past and the low absorption member 26 is further formed by a method publicly known in the past to fill the remaining space of the trench T2.

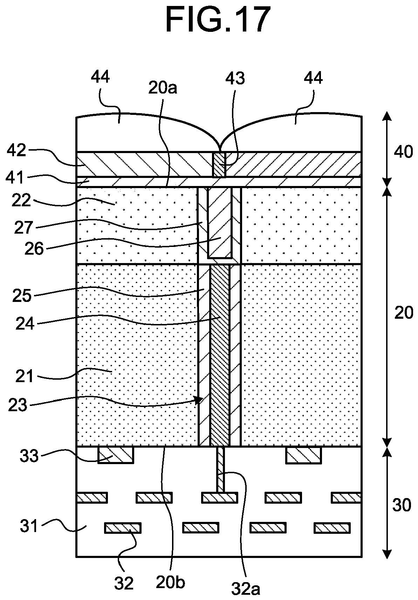

Subsequently, as illustrated in FIG. 17, a planarization film 41, the plurality of color filters 42, the plurality of light blocking walls 43, and the plurality of OCLs 44 are formed in order on the surface of the light incident surface 20a of the semiconductor layer 20.

As described above, in the manufacturing step in the modification 1, the separation region 23 is formed by filling the trench T1 formed from the opposite surface 20b with the insulating film 25 and the wall-like electrode 24 and filling the trench T2 formed from the light incident surface 20a with the fixed charge film 27 and the low absorption member 26.

Therefore, according to the modification 1, since the low absorption member 26 is not exposed to a high temperature environment in, for example, a step of forming the wiring layer 30, it is possible to prevent such a low absorption member 26 from being deteriorated.

Note that, in the manufacturing steps in the embodiment and the modification 1 explained above, an example is explained in which the first region 21 and the second region 22 are formed by ion-implanting impurities of the second conductivity type with high energy into the semiconductor substrate 120 of the first conductivity type. However, the present disclosure is not limited to such an example.

For example, in the technology of the present disclosure, the first region 21 and the second region 22 may be formed by ion-implanting impurities of the first conductivity type with relatively low energy from the opposite surface 20b side of the semiconductor substrate 120 of the second conductivity type.

### <Modification 2>

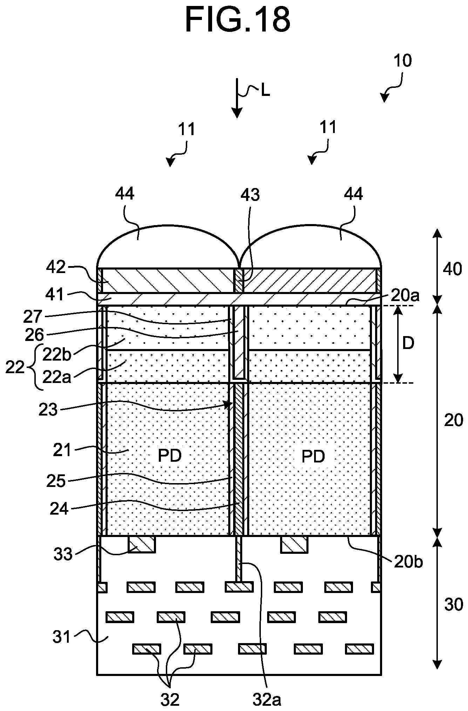

FIG. 18 is a sectional view schematically illustrating structure of the pixel array section 10 according to a modification 2 of the embodiment of the present disclosure. Such a modification 2 is different from the modification 1 in a configuration of the second region 22.

Specifically, as illustrated in FIG. 18, in the modification 2, the second region 22 includes a first part 22a disposed on the first region 21 side and a second part 22b disposed on the light incident surface 20a side.

The first part 22a is a region having impurity concentration lower than that of the first region 21 and is, for example, an impurity region of the first conductivity type having impurity concentration lower than that of the first region 21. The second part 22b is a region having impurity concentration lower than that of the first part 22a and is, for example, an impurity region of the second conductivity type.

Consequently, it is possible to further suppress occurrence of abnormal charges due to a defect or the like of the semiconductor layer 20 in the vicinity of the interface between the low absorption member 26 to which a negative bias voltage is not applied and the second region 22. Therefore, according to the modification 2, occurrence of white spots in the photodiode PD can be further suppressed.

### <Modification 3>

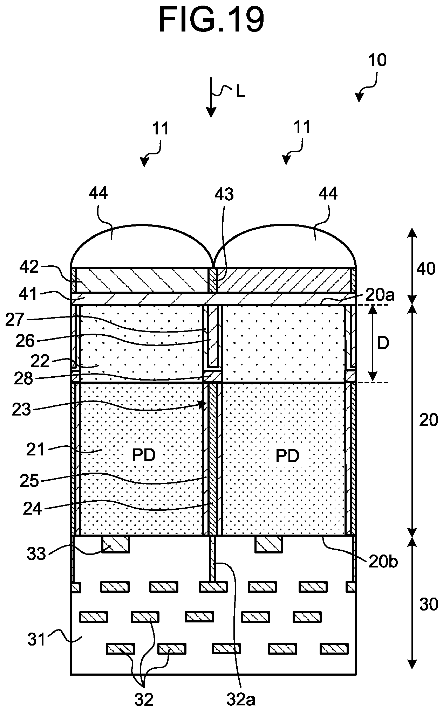

FIG. 19 is a sectional view schematically illustrating structure of the pixel array section 10 according to a modification 3 of the embodiment of the present disclosure. In such a modification 3, a configuration around the low absorption member 26 is different from that in the modification 1.

Specifically, as illustrated in FIG. 19, in the modification 3, a stopper film 28 is disposed between the low absorption member 26 and the fixed charge film 27 and the wall-like electrode 24 and the insulating film 25. Such the stopper film 28 is formed to fill the bottom of the trench T1 during the period until the insulating film 25 and the wall-like electrode 24 are formed after the trench T1 is formed in the manufacturing step illustrated in FIG. 12.

The stopper film 28 is made of a material (for example, silicon oxide or silicon nitride) having a high selection ratio of etching with respect to the material of the semiconductor layer 20 (for example, silicon).

In the modification 3, since such the stopper film 28 is disposed, the stopper film 28 can be used as an etching stopper in the step of forming the trench T2 illustrated in FIG. 15. Therefore, according to the modification 3, the trench T2 can be accurately formed.

### <Modification 4>

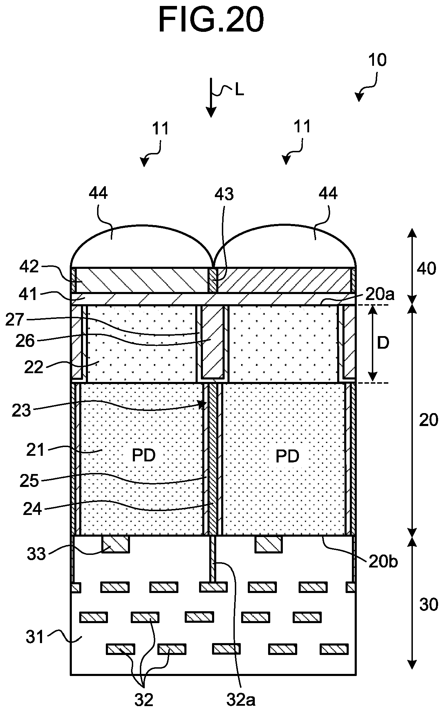

FIG. 20 is a sectional view schematically illustrating structure of the pixel array section 10 according to a modification 4 of the embodiment of the present disclosure. In such a modification 4, the sizes of the low absorption member 26 and the fixed charge film 27 are different from those in the modification 1.

Specifically, as illustrated in FIG. 20, in the modification 4, a wall-like part configured by the low absorption member 26 and the fixed charge film 27 is thicker than a wall-like part including the wall-like electrode 24 and the insulating film 25.

Consequently, even when the trench T2 is displaced with respect to the trench T1 in the step of forming the trench T2, the wall-like part configured by the low absorption member 26 and the fixed charge film 27 can be connected to a wall-like part configured by the wall-like electrode 24 and the insulating film 25.

Therefore, according to the modification 4, even when the trench T2 is displaced with respect to the trench T1, the adjacent photodiodes PD can be reliably separated in the separation region 23.

### <Modification 5>

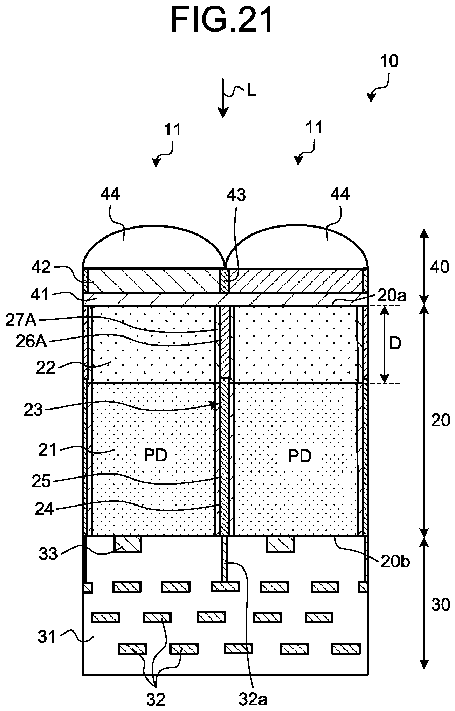

FIG. 21 is a sectional view schematically illustrating structure of the pixel array section 10 according to a modification 5 of the embodiment of the present disclosure. In the modification 5, configurations of the low absorption member 26 and the fixed charge film 27 are different from those in the modification 1.

Specifically, as illustrated in FIG. 21, in the modification 5, a low absorption member 26A is made of a conductive material (for example, tungsten or aluminum) and a fixed charge film 27A is made of an insulating material (for example, silicon oxide). In the modification 5, the low absorption member 26A and the wall-like electrode 24 are electrically connected to each other.

Consequently, since a negative bias voltage is applied to the low absorption member 26A as well via the wall-like electrode 24, holes can be collected in the vicinity of the interface between the second region 22 and the separation region 23 as well. Therefore, according to the modification 5, occurrence of a dark current and white spots in the photodiode PD can be further suppressed.

### <Modification 6>

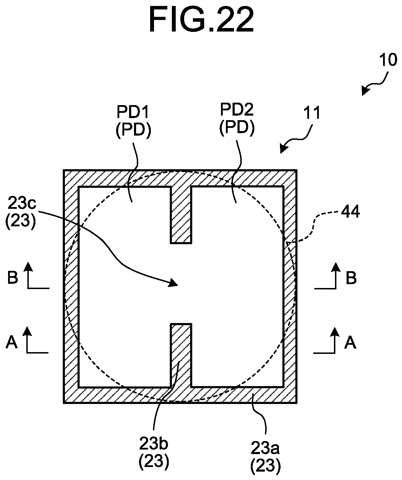

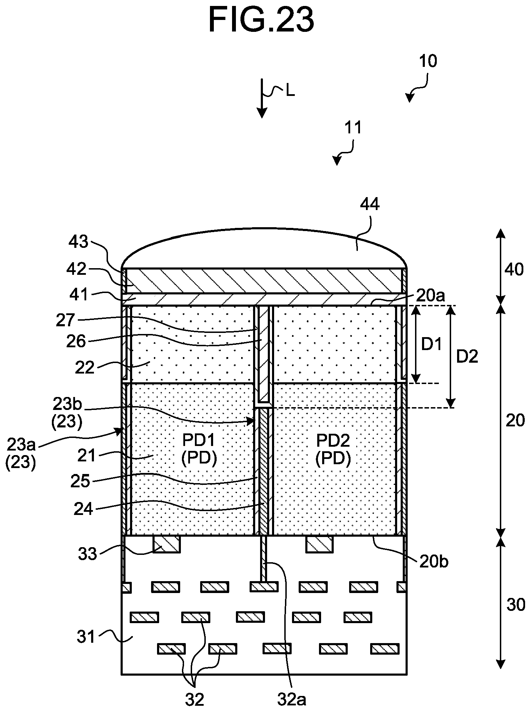

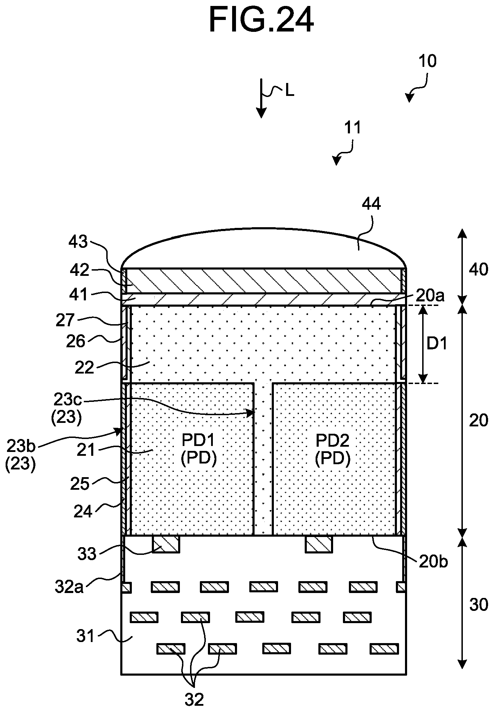

FIG. 22 is a diagram illustrating a planar configuration of the pixel array section 10 according to a modification 6 of the embodiment of the present disclosure. FIG. 23 is an arrow sectional view taken along line A-A illustrated in FIG. 22. FIG. 24 is an arrow sectional view taken along line B-B illustrated in FIG. 22.

As illustrated in FIG. 22 and the like, in the pixel array section 10 in the modification 6, a pair of photodiodes PD (hereinafter also referred to as photodiodes PD1 and PD2) are provided in one light receiving pixel 11. For example, the light receiving pixel 11 has a substantially square shape in plan view and the photodiode PD has a substantially rectangular shape in plan view.

The light receiving pixel 11 includes, as the separation region 23, a first separation region 23a, a second separation region 23b, and an impurity region 23c. As illustrated in FIG. 22, the first separation region 23a is disposed to surround a pair of photodiodes PD1 and PD2 in one light receiving pixel 11.

The second separation region 23b is disposed between the pair of photodiodes PD1 and PD2 adjacent to each other in one light receiving pixel 11. The second separation region 23b optically and electrically separates the pair of photodiodes PD1 and PD2 adjacent to each other.

That is, in the light receiving pixel 11 in the modification 6, the first separation region 23a separates the plurality of photodiodes PD on which the light L is made incident via different OCLs 44. The second separation region 23b separates the pair of photodiodes PD1 and PD2 on which the light L is made incident via the same OCL 44.

As explained above, in the modification 6, since the pair of photodiodes PD1 and PD2 can be separated from each other using the second separation region 23b, a phase difference of the incident light L can be detected using the pair of photodiodes PD1 and PD2.

The impurity region 23c is disposed in a position different from the second separation region 23b in plan view between the pair of photodiodes PD1 and PD2 and includes impurities of the second conductivity type.

The impurity region 23c functions as an overflow path between the photodiode PD1 and the photodiode PD2. Consequently, in the modification 6, charge amounts accumulated in both of the photodiodes PD1 and PD2 can be equalized.

Here, in the modification 6, as illustrated in FIG. 23, as in the modification 1 explained above, the first separation region 23a and the second separation region 23b include the wall-like electrode 24, the insulating film 25, the low absorption member 26, and the fixed charge film 27.

Consequently, in the modification 6, it is possible to impart satisfactory separation characteristics to the first separation region 23a and the second separation region 23b and it is possible to prevent the light L from being absorbed in parts on the light incident side in the first separation region 23a and the second separation region 23b.

Therefore, according to the modification 6, in the light receiving pixel 11 that can detect a phase difference of the light L, it is possible to suppress deterioration in a condensing characteristic for the pair of photodiodes PD1 and PD2.

In the modification 6, as illustrated in FIG. 23, depth D2 at which the low absorption member 26 and the fixed charge film 27 are disposed in the second separation region 23b is preferably larger than depth D1 at which the low absorption member 26 and the fixed charge film 27 are disposed in the first separation region 23a.

Consequently, the light L can be effectively prevented from being absorbed in a part further on the light incident side in the second separation region 23b where more light L is condensed than in the first separation region 23a because the second separation region 23b is disposed near the optical axis of the OCL 44.

Therefore, according to the modification 6, in the light receiving pixel 11 that can detect a phase difference of the light L, it is possible to further suppress deterioration of the condensing characteristic for the pair of photodiodes PD1 and PD2.

Note that, in an example illustrated in FIG. 22 to FIG. 24, the phase difference pixel in which the overflow path (the impurity region 23c) is disposed between the pair of photodiodes PD1 and PD2 are illustrated. However, the present disclosure is not limited to such an example.

For example, in the phase difference pixel in which the pair of photodiodes PD1 and PD2 is completely separated by the second separation region 23b, the first separation region 23a and the second separation region 23b may include the wall-like electrode 24, the insulating film 25, the low absorption member 26, and the fixed charge film 27.

Consequently, in the light receiving pixel 11 that can detect a phase difference of the light L, it is possible to suppress deterioration in the condensing characteristic for the pair of photodiodes PD1 and PD2.

In this phase difference pixel, the depth D2 at which the low absorption member 26 and the fixed charge film 27 are disposed in the second separation region 23b may be larger than the depth D1 at which the low absorption member 26 and the fixed charge film 27 are disposed in the first separation region 23a. Consequently, it is possible to further suppress deterioration in the condensing characteristic for the pair of photodiodes PD1 and PD2.

### [Effects]

The solid-state imaging element 1 according to the embodiment includes the semiconductor layer 20 and the separation region 23. The semiconductor layer 20 includes a plurality of photoelectric conversion sections (photodiodes PD) disposed in a matrix. The separation region 23 separates adjacent photoelectric conversion sections (photodiodes PD) in the semiconductor layer 20. The separation region 23 includes the wall-like electrode 24 and the low absorption member 26. The wall-like electrode 24 is disposed in a wall shape and a negative bias voltage is applied thereto. The low absorption member 26 is disposed further on the light incident side than the wall-like electrode 24 and has a light absorption rate smaller than that of the wall-like electrode 24.

Consequently, it is possible to suppress deterioration in the condensing characteristic for the photodiode PD.

In the solid-state imaging element 1 according to the embodiment, the photoelectric conversion section (the photodiode PD) includes the first region 21 adjacent to the wall-like electrode 24 and the second region 22 adjacent to the low absorption member 26. The impurity concentration of the second region 22 is lower than the impurity concentration of the first region 21.

Consequently, occurrence of white spots in the photodiode PD can be suppressed.

In the solid-state imaging element 1 according to the embodiment, the low absorption member 26 is disposed up to the depth D of 800 (nm) or more from the surface 20a on the light incident side of the semiconductor layer 20.

Consequently, it is possible to further improve the condensing characteristic for the photodiode PD.

In the solid-state imaging element 1 according to the embodiment, the wall-like electrode 24 is mainly configured using one selected out of polysilicon, tungsten, and aluminum as a main component.

Consequently, occurrence of a dark current and white spots in the photodiode PD can be further suppressed.

In the solid-state imaging element 1 according to the embodiment, the low absorption member 26 is configured using one selected out of silicon oxide, hafnium oxide, aluminum oxide, and titanium oxide as a main component.

Consequently, the low absorption member 26 can be easily formed or scattering of the light L can be suppressed at the end portion on the light incident side in the low absorption member 26.

The solid-state imaging element 1 according to the embodiment further includes a plurality of on-chip lenses (OCLs 44) that make the light L incident on photoelectric conversion sections (photodiode PDs) corresponding thereto. The separation region 23 includes the first separation region 23a and the second separation region 23b. The first separation region 23a separates a plurality of photoelectric conversion sections (photodiodes PD) on which the light L is made incident via different on-chip lenses (OCLs 44). The second separation region 23b separates a plurality of photoelectric conversion sections (photodiodes PD) on which the light L is made incident via the same on-chip lens (OCL 44). The low absorption member 26 located in the second separation region 23b is disposed up to a position deeper than the low absorption member 26 located in the first separation region 23a.

Consequently, in the light receiving pixel 11 that can detect a phase difference of the light L, it is possible to further suppress deterioration in the condensing characteristic for the pair of photodiodes PD1 and PD2.

The method of manufacturing the solid-state imaging element 1 according to the embodiment includes a step of forming the trench T1, a step of filling the trench T1 with the low absorption member 26, a step of forming the insulating film 25, and a step of filling the trench T1 with the wall-like electrode 24. In the step of forming the trench T1, the trench T1 is formed on the surface 20b of the semiconductor substrate 120 on the opposite side of the light incident side. In the step of filling the trench T1 with the low absorption member 26, the trench T1 is filled with the low absorption member 26 up to the given depth X from the bottom of the trench T1. In the step of forming the insulating film 25, the insulating film 25 is formed on the side surface T1a from the given depth X of the trench T1 to the opening. In the step of filling the trench T1 with the wall-like electrode 24, the remaining part of the trench T1 is filled with the conductive wall-like electrode 24. The wire 32a formed in the wiring layer 30 is connected to the wall-like electrode 24. The low absorption member 26 has a light absorption rate smaller than that of the wall-like electrode 24.

Consequently, it is possible to easily form the solid-state imaging element 1 in which deterioration in the condensing characteristic for the photodiode PD is suppressed and it is possible to prevent positional deviation between the low absorption member 26 and the wall-like electrode 24.

The method of manufacturing the solid-state imaging element 1 according to the embodiment further includes a step of reducing impurity concentration. In the step of reducing impurity concentration, impurity concentration of a region from depth corresponding to the bottom of the trench T1 to the given depth X is reduced to be smaller impurity concentration of a region from the given depth X to the surface 20b on the opposite side of the light incident side of the semiconductor substrate 120.

Consequently, it is possible to form the solid-state imaging element 1 in which occurrence of white spots in the photodiode PD is suppressed.

### [Electronic equipment]

Note that the present disclosure is not limited to application to the solid-state imaging element. That is, the present disclosure is applicable to, besides the solid-state imaging element, all kinds of electronic equipment including the solid-state imaging element such as a camera module, an imaging device, a mobile terminal device having an imaging function, or a copying machine using the solid-state imaging element in an image reading section.

Examples of such an imaging device include a digital still camera and a video camera. Examples of such a portable terminal device having the imaging function include a smartphone and a tablet terminal.

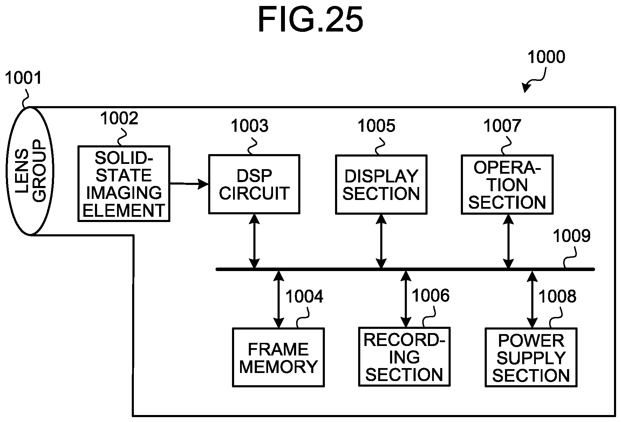

FIG. 25 is a block diagram illustrating a configuration example of an imaging device functioning as electronic equipment 1000 to which the technology according to the present disclosure is applied. The electronic equipment 1000 in FIG. 25 is, for example, electronic equipment such as an imaging device such as a digital still camera or a video camera or a mobile terminal device such as a smartphone or a tablet terminal.

In FIG. 25, the electronic equipment 1000 is configured from a lens group 1001, a solid-state imaging element 1002, a DSP circuit 1003, a frame memory 1004, a display section 1005, a recording section 1006, an operation section 1007, and a power supply section 1008.

In the electronic equipment 1000, the DSP circuit 1003, the frame memory 1004, the display section 1005, the recording section 1006, the operation section 1007, and the power supply section 1008 are mutually connected via a bus line 1009.

The lens group 1001 captures incident light (image light) from a subject and forms an image on an imaging surface of the solid-state imaging element 1002. The solid-state imaging element 1002 corresponds to the solid-state imaging element 1 according to the embodiment explained above and converts an amount of the incident light imaged on the imaging surface by the lens group 1001 into an electric signal in sections of pixels and outputs the electric signal as a pixel signal.

The DSP circuit 1003 is a camera signal processing circuit that processes a signal supplied from the solid-state imaging element 1002. The frame memory 1004 temporarily holds image data processed by the DSP circuit 1003 in sections of frames.

The display section 1005 is configured from, for example, a panel type display device such as a liquid crystal panel or an organic electro luminescence (EL) panel and displays a moving image or a still image captured by the solid-state imaging element 1002. The recording section 1006 records image data of a moving image or a still image captured by the solid-state imaging element 1002 in a recording medium such as a semiconductor memory or a hard disk.

The operation section 1007 issues operation commands for various functions of the electronic equipment 1000 according to an operation by a user. The power supply section 1008 appropriately supplies various kinds of electric power serving as operation power for the DSP circuit 1003, the frame memory 1004, the display section 1005, the recording section 1006, and the operation section 1007 to these supply targets.

In the electronic equipment 1000 configured as explained above, by applying, as the solid-state imaging element 1002, the solid-state imaging element 1 in the embodiments explained above, it is possible to suppress deterioration in the condensing characteristic for the photodiode PD.

### [Application example to a mobile body]

The technology according to the present disclosure (the present technology) can be applied to various products. For example, the technology according to the present disclosure may be implemented as a device mounted on a mobile body of any type such as an automobile, an electric vehicle, a hybrid electric vehicle, a motorcycle, a bicycle, a personal mobility, an airplane, a drone, a ship, and a robot.

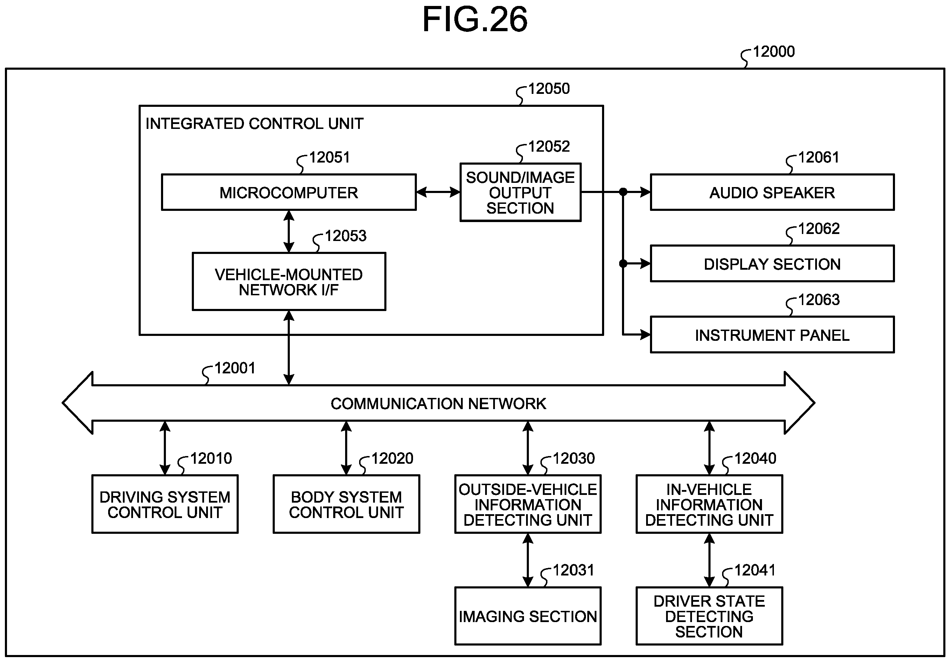

FIG. 26 is a block diagram depicting an example of schematic configuration of a vehicle control system as an example of a mobile body control system to which the technology according to an embodiment of the present disclosure can be applied.

A vehicle control system 12000 includes a plurality of electronic control units connected to each other via a communication network 12001. In the example depicted in FIG. 26, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 26, an audio speaker 12061, a display section 12062, and an instrument panel 12063 are illustrated as the output device. The display section 12062 may, for example, include at least one of an on-board display and a head-up display.

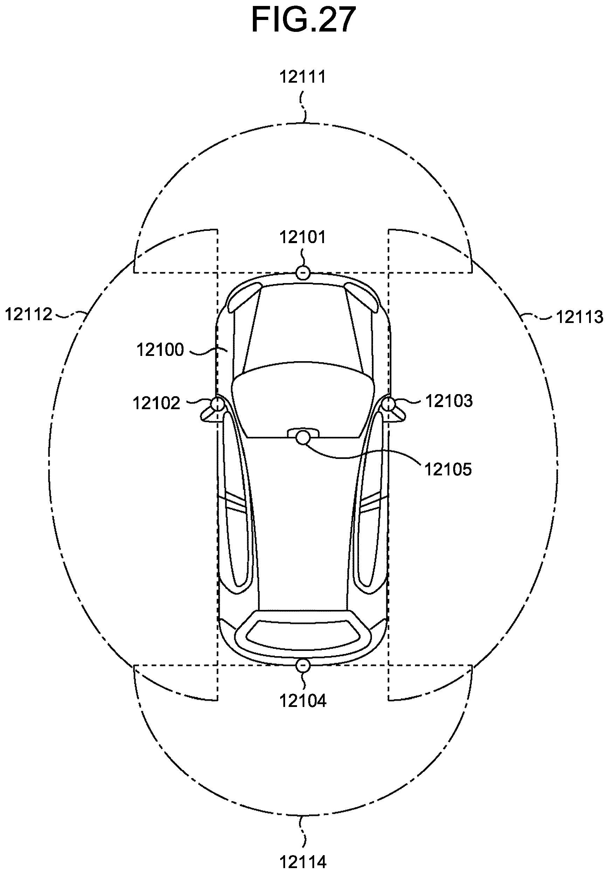

FIG. 27 is a diagram depicting an example of the installation position of the imaging section 12031.

In FIG. 27, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of a vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 27 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

The example of the vehicle control system to which the technology according to the present disclosure can be applied is explained above. The technology according to the present disclosure can be applied to the imaging section 12031 among the configurations explained above. Specifically, the solid-state imaging element 1 in FIG. 1 can be applied to the imaging section 12031. By applying the technology according to the present disclosure to the imaging section 12031, a high-quality image can be acquired from the imaging section 12031.

Although the embodiments of the present disclosure are explained above, the technical scope of the present disclosure is not limited to the embodiments explained above per se. Various changes are possible without departing from the gist of the present disclosure. Components in different embodiments and modifications may be combined as appropriate.

The effects described in the present specification are only examples and are not limited. There may be other effects.

Note that the present technology can also take the following configurations.
(1) A solid-state imaging element comprising:
   a semiconductor layer including a plurality of photoelectric conversion sections disposed in a matrix; and
   a separation region that separates the photoelectric conversion sections adjacent to each other in the semiconductor layer, wherein
   the separation region includes:
      a wall-like electrode disposed in a wall shape, a negative bias voltage being applied to the wall-like electrode; and
      a low absorption member disposed further on a light incident side than the wall-like electrode and having a light absorption rate smaller than a light absorption rate of the wall-like electrode.
(2) The solid-state imaging element according to the above (1), wherein
   the photoelectric conversion sections include a first region adjacent to the wall-like electrode and a second region adjacent to the low absorption member, and
   impurity concentration of the second region is lower than impurity concentration of the first region.
(3) The solid-state imaging element according to the above (1) or (2), wherein
   the low absorption member is disposed up to a depth of 800 (nm) or more from a light incident surface of the semiconductor layer.
(4) The solid-state imaging element according to any one of the above (1) to (3), wherein
   the wall-like electrode is configured using one selected out of polysilicon, tungsten, and aluminum as a main component.
(5) The solid-state imaging element according to any one of the above (1) to (4), wherein
   the low absorption member is configured using one selected out of silicon oxide, hafnium oxide, aluminum oxide, and titanium oxide as a main component.
(6) The solid-state imaging element according to any one of the above (1) to (5), further comprising
   a plurality of on-chip lenses that make light incident on the photoelectric conversion sections corresponding thereto, wherein
   the separation region includes:
      a first separation region that separates the plurality of photoelectric conversion sections on which light is made incident via different pieces of the on-chip lenses; and
      a second separation region that separates the plurality of photoelectric conversion sections on which light is made incident via a same piece of the on-chip lenses, and
      the low absorption member located in the second separation region is disposed to a position deeper than the low absorption member located in the first separation region.
(7) A method of manufacturing a solid-state imaging element, comprising:
   a step of forming a trench on a surface on an opposite side of a light incident side of a semiconductor substrate;
   a step of filling the trench with a low absorption member up to given depth from a bottom of the trench;
   a step of forming an insulating film on a side surface of the trench from the given depth to an opening of the trench;
   a step of filling a remaining part of the trench with a conductive wall-like electrode; and
   a step of forming a wiring layer on a surface on the light incident side of the semiconductor substrate, wherein
   a wire formed in the wiring layer is connected to the wall-like electrode, and
   the low absorption member has a light absorption rate smaller than a light absorption rate of the wall-like electrode.
(8) The method of manufacturing a solid-state imaging element according to the above (7), further comprising
   a step of reducing impurity concentration of in a region from depth corresponding to the bottom of the trench to the given depth to be lower than impurity concentration in a region from the given depth to the surface on the opposite side of the light incident side of the semiconductor substrate.
(9) Electronic equipment comprising:
   a solid-state imaging element;
   an optical system that captures incident light from a subject and forms an image on an imaging surface of the solid-state imaging element; and
   a signal processing circuit that performs processing on an output signal from the solid-state imaging element, wherein
   the solid-state imaging element includes:
      a semiconductor layer including a plurality of photoelectric conversion sections disposed in a matrix; and
      a separation region that separates the photoelectric conversion sections adjacent to each other in the semiconductor layer, and
      the separation region includes:
         a wall-like electrode disposed in a wall shape, a negative bias voltage being applied to the wall-like electrode; and
         a low absorption member disposed further on a light incident side than the wall-like electrode, the low absorption member having a light absorption rate smaller than a light absorption rate of the wall-like electrode.
(10) The electronic equipment according to the above (9), wherein
   the photoelectric conversion section has a first region adjacent to the wall-like electrode and a second region adjacent to the low absorption member, and
   impurity concentration of the second region is lower than impurity concentration of the first region.
(11) The electronic equipment according to the above (9) or (10), wherein
   the low absorption member is disposed up to depth of 800 (nm) or more from a light incident surface of the semiconductor layer.
(12) The electronic equipment according to any one of the above (9) to (11), wherein
   the wall-like electrode is configured using one selected out of polysilicon, tungsten, and aluminum as a main component.
(13) The electronic equipment according to any one of the above (9) to (12), wherein
   the low absorption member is configured using one selected out of silicon oxide, hafnium oxide, aluminum oxide, and titanium oxide as a main component.
(14) The electronic equipment according to any one of the above (9) to (13), further comprising
   a plurality of on-chip lenses that make light incident on the photoelectric conversion section corresponding thereto, wherein
   the separation region includes:
      a first separation region that separates a plurality of the photoelectric conversion sections on which light is made incident via different pieces of the on-chip lenses; and
      a second separation region that separates the plurality of photoelectric conversion sections on which light is incident via a same piece of the on-chip lenses, and
      the low absorption member located in the second separation region is disposed up to a position deeper than the low absorption member located in the first separation region.

### Reference Signs List

- 1: SOLID-STATE IMAGING ELEMENT
- 10: PIXEL ARRAY SECTION
- 11: LIGHT RECEIVING PIXEL
- 20: SEMICONDUCTOR LAYER
- 21: FIRST REGION
- 22: SECOND REGION
- 23: SEPARATION REGION
- 23a: FIRST SEPARATION REGION
- 23b: SECOND SEPARATION REGION
- 24: WALL-LIKE ELECTRODE
- 25: INSULATING FILM
- 26, 26A: LOW ABSORPTION MEMBER
- 27, 27A: FIXED CHARGE FILM
- 30: WIRING LAYER
- 32, 32a: WIRE
- 1000: ELECTRONIC EQUIPMENT
- PD, PD1, PD2: PHOTODIODE (EXAMPLE OF PHOTOELECTRIC CONVERSION SECTION)

## Claims

1. A solid-state imaging element comprising:
a semiconductor layer including a plurality of photoelectric conversion sections disposed in a matrix; and
a separation region that separates the photoelectric conversion sections adjacent to each other in the semiconductor layer, wherein
the separation region includes:
a wall-like electrode disposed in a wall shape, a negative bias voltage being applied to the wall-like electrode; and
a low absorption member disposed further on a light incident side than the wall-like electrode and having a light absorption rate smaller than a light absorption rate of the wall-like electrode.

2. The solid-state imaging element according to claim 1, wherein
the photoelectric conversion sections include a first region adjacent to the wall-like electrode and a second region adjacent to the low absorption member, and
impurity concentration of the second region is lower than impurity concentration of the first region.

3. The solid-state imaging element according to claim 1, wherein
the low absorption member is disposed up to a depth of 800 (nm) or more from a light incident surface of the semiconductor layer.

4. The solid-state imaging element according to claim 1, wherein
the wall-like electrode is configured using one selected out of polysilicon, tungsten, and aluminum as a main component.

5. The solid-state imaging element according to claim 1, wherein
the low absorption member is configured using one selected out of silicon oxide, hafnium oxide, aluminum oxide, and titanium oxide as a main component.

6. The solid-state imaging element according to claim 1, further comprising
a plurality of on-chip lenses that make light incident on the photoelectric conversion sections corresponding thereto, wherein
the separation region includes:
a first separation region that separates the plurality of photoelectric conversion sections on which light is made incident via different pieces of the on-chip lenses; and
a second separation region that separates the plurality of photoelectric conversion sections on which light is made incident via a same piece of the on-chip lenses, and
the low absorption member located in the second separation region is disposed to a position deeper than the low absorption member located in the first separation region.

7. A method of manufacturing a solid-state imaging element, comprising:
a step of forming a trench on a surface on an opposite side of a light incident side of a semiconductor substrate;
a step of filling the trench with a low absorption member up to given depth from a bottom of the trench;
a step of forming an insulating film on a side surface of the trench from the given depth to an opening of the trench;
a step of filling a remaining part of the trench with a conductive wall-like electrode; and
a step of forming a wiring layer on a surface on the light incident side of the semiconductor substrate, wherein
a wire formed in the wiring layer is connected to the wall-like electrode, and
the low absorption member has a light absorption rate smaller than a light absorption rate of the wall-like electrode.

8. The method of manufacturing a solid-state imaging element according to claim 7, further comprising
a step of reducing impurity concentration of in a region from depth corresponding to the bottom of the trench to the given depth to be lower than impurity concentration in a region from the given depth to the surface on the opposite side of the light incident side of the semiconductor substrate.

9. Electronic equipment comprising:
a solid-state imaging element;
an optical system that captures incident light from a subject and forms an image on an imaging surface of the solid-state imaging element; and
a signal processing circuit that performs processing on an output signal from the solid-state imaging element, wherein
the solid-state imaging element includes:
a semiconductor layer including a plurality of photoelectric conversion sections disposed in a matrix; and
a separation region that separates the photoelectric conversion sections adjacent to each other in the semiconductor layer, and
the separation region includes:
a wall-like electrode disposed in a wall shape, a negative bias voltage being applied to the wall-like electrode; and
a low absorption member disposed further on a light incident side than the wall-like electrode, the low absorption member having a light absorption rate smaller than a light absorption rate of the wall-like electrode.
